# NEUE EUROPÄISCHE PATENTSCHRIFT

(11) **EP 0 744 031 B2**
(45) Veröffentlichungstag und Bekanntmachung des Hinweises auf die Entscheidung über den Einspruch: **09.07.2003**
(45) Hinweis auf die Patenterteilung: 14.06.2000
(21) Anmeldenummer: 95907561.5
(22) Anmeldetag: 07.02.1995
(51) Int. Cl.: G01P 21/00

(54) **VERFAHREN ZUR HERSTELLUNG EINER KALIBRIERTEN SENSOREINHEIT**
A PROCESS FOR PRODUCING A CALIBRATED SENSOR UNIT
PROCEDE DE PRODUCTION D'UNE UNITE DE DETECTION ETALONNEE

(30) Priorität: 10.02.1994 DE 4404265
(43) Veröffentlichungstag der Anmeldung: 27.11.1996
(73) Patentinhaber: SIEMENS AKTIENGESELLSCHAFT, 80333 München (DE)
(72) Erfinder: BELAU, Horst, D-93309 Kehlheim-Kapfelberg (DE); SWART, Marten, D-93083 Obertraubling (DE); PUNZMANN, Horst, D-93053 Regensburg (DE)
(86) Internationale Anmeldenummer: DE9500162
(87) Internationale Veröffentlichungsnummer: WO95022063

(56) Entgegenhaltungen:
- EP-A- 0 557 592
- WO-A-90/07718
- DE-A- 4 022 697
- DE-A- 4 108 081
- IEEE Standard Specification Format Guide and Test Procedure for Linear, Single-Axis, Pendulous, Analog Torque Balance Accelerometer, The Institute of Electrical and Electronics Engineers, Inc., 1972, S. 28,29
- Walter Heywang: Sensorik, Springer Verlag, Berlin, 1984, S. 131-133 und S. 203-206
- International Standard ISO 5347-5 First Edition 1993-12-15, Methods for the calibration of vibration and shock pick-ups, Part 5: Calibration by Earth's gravitation, S. 1,2
- Cyril M. Harris und Charles E. Crede: Shock and Vibration Handbook, 2. Auflage, McGraw-Hill, New York, S. 18-3, 18-4

## Beschreibung

Die Erfindung betrifft ein Verfahren zur Herstellung einer kalibrierten Sensoreinheit im Rahmen einer Serienfertigung mittels einer automatisierten Fertigungsanlage, wobei die Sensoreinheit einen eine seismische Masse aufweisenden Beschleunigungssensor und eine zur Auswertung der Ausgangssignale des Beschleunigungssensors und zur Lieferung von Beschleunigungssignalen (C) dienende Elektronikeinheit enthält.

Derartige Sensoreinheiten dienen zur Messung von Beschleunigungen bzw. Verzögerungen. Sie müssen oft enge Toleranzen einhalten, besonders wenn sie z. B. zur Steuerung der Auslösung von Insassenschutzsystemen in Kfz dienen, also z. B. zur Steuerung der Auslösung von Airbags.

Bekannte Beschleunigungssensoren funktionieren nach unterschiedlichen Prinzipien. Allen ist gemeinsam, daß das Basiselement aufgrund von Fertigungstoleranzen erhebliche Streuungen bezüglich der Beschleunigungsempfindlichkeit aufweist. Ein Hauptproblem solcher Sensoreinheiten ist diese fertigungstechnisch bedingte, sehr hohe Streuung ihrer Empfindlichkeit, z.B. ausdrückbar in µV/a (= Mikrovolt pro Beschleunigungseinheit), wobei µV der Höhe des Ausgangssignales und a der Stärke der Beschleunigung bzw. Verzögerung entspricht, die z.B. in Vielfachen der Erdbeschleunigung g gemessen wird.

Die Empfindlichkeit µV/a der einzelnen in Massenfertigung hergestellten Exemplare der Beschleunigungssensoren streuen z.B. um ± 25 %. Zur Steuerung von z. B. Airbags in Kfz ist aber eine sehr viel engere Toleranz dringend nötig. Das ist vor allem dann wichtig, wenn die Sensoreinheiten zusammen mit ebenfalls in Massenfertigung hergestellten Elektronikeinheiten ohne zusätzliche weitere Justierungen kombiniert werden sollen, wobei diese Elektronikeinheiten z.B. das Sensorsignal verarbeiten und/oder unmittelbar zur präzisen Steuerung der Auslösung der Insassenschutzeinrichtungen eines ganz speziellen Fahrzeugtypes mit seinerseits jeweils ganz speziellen Konstruktionsmerkmalen dienen.

Aus der DE 38 44 351 A1 ist es bekannt, Sensoren für Beschleunigungen, ohne eine vorherige Klassifizierung nach Empfindlichkeitsklassen vorzunehmen, lediglich mittels eines Feinabgleichs abzugleichen. Jedoch erfolgt auch dieser Feinabgleich zusätzlich separat nach der Herstellung des Sensors.

Aufgabe der vorliegenden Erfindung ist es, diese Toleranz bei der Empfindlichkeit schon während der automatisierten Massenfertigung der Sensoreinheiten durch entsprechendes Kalibrieren erheblich einzuengen, so daß alle hergestellten Sensoreinheiten schließlich angenähert dieselbe enge Steilheit besitzen.

Diese Aufgabe wird erfindungsgemäß für das obengenannte Verfahren durch die im Anspruch 1 genannten Merkmale gelöst.

Die Erfindung vermeidet den oben geschilderten Aufwand zur Einengung der Toleranzen. Die Erfindung eignet sich daher vor allem die aufwandsarme Massenfertigung von kalibrierten Sensoreinheiten.

Die Erfindung ist prinzipiell auf alle Beschleunigungssensoren anwendbar und eignet sich besonders bei Sensoreinheiten mit digitalem Ausgangssignal.

Weitere Ausgestaltungen der Erfindung ergeben sich aus den Unteransprüchen.

Zusammenfassend bestehen die Vorteile der vorliegenden Erfindung darin,
jeweils auf besonders einfache und für Großserienfertigungen geeignete Weise die Elektronikeinheit justieren zu können, auf besonders einfache, für Großserienfertigung geeignete Weise die zur Messung nötigen Spannungen zuführen zu können, auf besonders einfache, für Großserienfertigung geeignete Weise die Sensoreinheiten an ihren Meßplätzen vorbeileiten zu können,
eine besonders hohe Justiergenauigkeit mit wenig Aufwand erreichen zu können,
in für Großserienfertigung besonders geeigneter Weise zunächst nur die Verbindungen des Beschleunigungssensors mit der Elektronikeinheit, aber noch nicht die Verbindungen mit den Außenanschlüssen der Sensoreinheit herzustellen, so daß sich während der ersten Messung die betreffende Sensoreinheit und die übrigen - insbesondere auf dem Band befestigten - Sensoreinheiten nicht gegenseitig störend beeinflussen und/oder daß sich andernfalls Kurzschlüsse zwischen diesen Anschlüssen ergeben würden,
in für eine Großserienfertigung besonders geeigneter Weise die zu justierenden Sensoreinheiten auf dem Band anzubringen, zu justieren und anschließend voneinander trennen zu können, in für eine Großserienfertigung besonders geeigneter Weise die justierten Sensoreinheiten gegen Umwelteinflüsse zu schützen,
einen besonders raumsparenden Aufbau der Sensoreinheit zu bieten, und
eine besonders toleranzarme Sensoreinheit zu ermöglichen.

Nachfolgend wird die Erfindung anhand eines in der Zeichnung dargestellten Ausführungsbeispiels näher beschrieben.

Es zeigen:
- Fig 1: eine Sensoreinheit in der Draufsicht,
- Fig 2: dieselbe Sensoreinheit in einer Seitenansicht,
- Fig 3: ein Schema für eine Fertigungsanlage zur Durchführung des erfindungsgemäßen Verfahrens mit einem S-förmig bewegtem Band, und
- Fig 4: ein Diagramm zur Veranschaulichung der erreichbaren Justiergenauigkeit, abhängig von der Stellung der Sensoreinheit bei den zwei Meßplätzen.

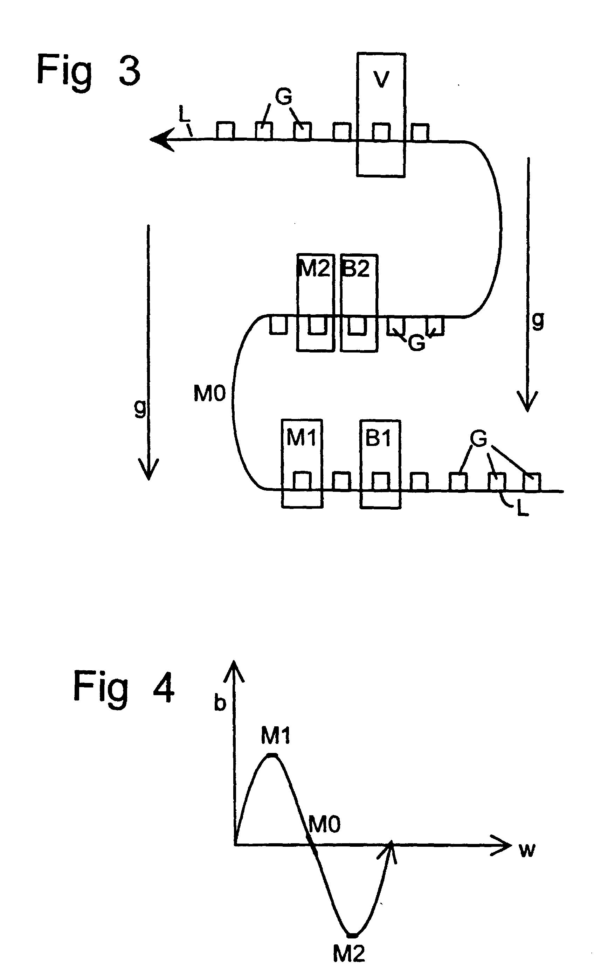

In der Figur 3 ist ein Beispiel für eine Fertigungsanlage gezeigt, auf welcher die Ausgangssignale eines Beschleunigungssensors im Rahmen einer Großserienfertigung von Sensoreinheiten vollautomatisch erfindungsgemäß kalibriert werden. Dieses Beispiel weist fünf, jeweils mit einem eigenen Roboter bestückte Arbeitsplatze B1, M1, M2, B2, V auf, wobei diese Arbeitsplätze räumlich teils nebeneinander, teils übereinander angeordnet sind, vgl. die in der Figur 3 gezeigte Richtung g der Erdanziehung/Gravitation.

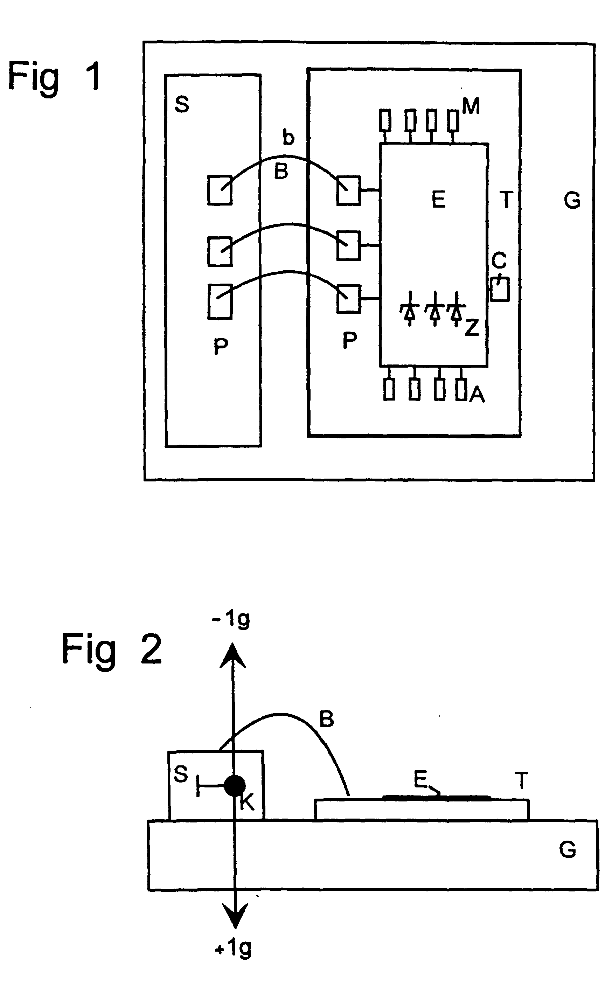

Alle gezeigten Gehäuseteile G enthalten jeweils eine Sensoreinheit S, E/T, vgl. das in den Figuren 1 und 2 gezeigte Beispiel einer Sensoreinheit, wobei alle Gehäuseteile G in Reihe hintereinander auf einem Band L befestigt sind. Diese Sensoreinheiten enthalten jeweils einen Beschleunigungssensor S, welcher Ausgangssignale b, vgl. die Figur 1, entsprechend der aktuellen Beschleunigung/Verzögerung dieses Beschleunigungssensors liefert. Die Sensoreinheiten enthalten ferner jeweils eine Elektronikeinheit E/T, die zur Auswertung der Ausgangssignale b sowie zur Lieferung von Beschleunigungssignalen, vgl. den Ausgangsanschluß C der Elektronikeinheit E, dienen. Die gezeigten Sensoreinheiten S enthalten ihrerseits jeweils eine seismische Masse, welche in der Figur 2 symbolisch als eine Kugel K, die an einem federnden Hebelarm befestigt ist, dargestellt ist. - In der Regel wird aber die seismische Masse K eine andere Form und eine andere Befestigung am Beschleunigungssensor S besitzen.

Das Band L läuft S-förmig von rechts unten nach links oben an den fünf Arbeitsplätzen vorbei.

Die Richtung g der Gravitation hat bei der Erfindung hohe Bedeutung, weil sie zum Kalibrieren der Sensoreinheiten S, E/T benutzt wird, indem die Ausgangssignale b der Beschleunigungssensoren S, vgl. die Figur 1, in zwei gegeneinander gekippten Stellungen des Beschleunigungssensors S, vgl. die Stellungen an den beiden, in der Figur 3 gezeigten Meßplätzen M1 und M2, gemessen und diese Meßergebnisse anschließend miteinander verglichen werden.

Am ersten Arbeitsplatz B1 werden im in der Figur 3 gezeigten Beispiel bestimmte Bonddrähte B in den einzelnen Sensoreinheiten S, E/T angebracht, vgl. die Bonddrähte B in der Figur 1 zwischen elektrischen Anschlüssen P des Beschleunigungssensors S und elektrischen Anschlüssen P der auf dem Halbleiterchip T in integrierter Weise angebrachten Elektronikeinheit E.

Am nächsten Arbeitsplatz M1 finden die ersten Messungen an den Sensoreinheiten S, E/T statt, während die betreffende Sensoreinheit durch die Fertigungsanlage in einer ersten horizontalen Stellung gehalten wird, bei der die Gravitation g die seismische Masse K nach unten zieht. Dabei wird über Kontaktfinger eines Meßroboters den in der Figur 1 gezeigten Anschlüssen M Betriebsspannungen zugeleitet, wobei über solche Anschlüsse M mittelbar oder unmittelbar die durch die Gravitation +1g ausgelösten Ausgangssignale b des betreffenden Beschleunigungssensors S gemessen werden, vgl. die Figur 2. Die so gemessenen ersten Meßwerte werden in einem - in den Figuren nicht gezeigten - Speicher einer elektronischen Meßschaltung, die den beiden Meßrobotern M1, M2 gemeinsam ist, zwischengespeichert.

Danach durchläuft das Band L einen Bogen nach oben, wodurch dieselbe Sensoreinheit S, E/T schließlich um 180° gekippt am zweiten Meßplatz M2 vorbeiläuft. Die Fertigungsanlage hält also die Sensoreinheit S, E/T während der zweiten Messung M2 des Ausgangssignales b in einer zweiten Stellung, die gegenüber der ersten Stellung so gekippt ist, daß die Gravitation g die seismische Masse K in die entgegengesetzte Richtung zieht, die sich von der am ersten Meßplatz M1 gegebenen Gravitationsrichtung deutlich unterscheidet. Im gezeigten Beispiel wirkte am ersten Meßplatz M1 die Kraft +1g, und am zweiten Meßplatz - 1g auf die seismische Masse K, so daß die Differenz der Ausgangssignale b der Kraft 2g an der seismischen Masse K entspricht, also hier der doppelten Erdbeschleunigung g. Zur Durchführung der zweiten Messung wird über Kontaktfinger eines weiteren, dem zweiten Meßplatz M2 zugeordneten Meßroboters wieder den in der Figur 1 gezeigten Anschlüssen M Betriebsspannungen zugeleitet sowie über solche Anschlüsse M mittelbar oder unmittelbar die durch die Gravitation -1g ausgelösten Ausgangssignale b des betreffenden Beschleunigungssensors S gemessen.

Danach vergleicht die mit dem am Meßplatz M2 verbundene Meßschaltung die bei der ersten und der zweiten Messung M1, M2 an diesem Beschleunigungssensor S gemessenen Ausgangssignale b. Das Ergebnis dieses Vergleiches oder ein daraus abgeleiteter Wert stellt einen Kalibrierwert dar, der den Einfluß der Gravitation g auf das Ausgangssignal b beschreibt.

Schließlich wird erfindungsgemäß die Elektronikeinheit E/T - und/oder der Beschleunigungssensor S - entsprechend diesem Kalibrierwert durch Anlegen von elektrischen Impulsen - z.B. über die zum Kalibrieren bestimmten elektrischen Anschlüsse A - so justiert, daß die Elektronikeinheit E/T später die Ausgangssignale b in kalibrierte Beschleunigungssignale umwandeln kann - die kalibrierten Beschleunigungssignale treten dann am Anschluß C auf.

Zur Justierung der Elektronikeinheit E und/oder des Beschleunigungssensors S entsprechend dem Kalibrierwert gibt es mehrere Möglichkeiten.

Besonders günstig erwies sich, dazu in oder an der Elektronikeinheit E/T mindestens einen Spannungsteiler anzubringen, wobei der Spannungsteiler entsprechend dem Ergebnis des Vergleiches nachträglich so justiert wird, daß damit die Elektronikeinheit E/T später die Ausgangssignale b in kalibrierte Beschleunigungssignale C umwandeln kann. Dazu gibt es vor allem zwei günstige Varianten:

Man kann die einzelnen Abschnitte des Spannungsteilers zunächst mittels Zenerdioden Z überbrücken, die zur Justierung des Spannungsteiles entsprechend dem Kalibrierwert durch den Spannungsimpuls/durch Spannungsimpulse in Kurzschlüsse umgewandelt werden können. So kann man mittels der dem Kalibrierwert angepaßten Spannungsimpulse nachträglich einzelne Abschnitte des Spannungsteilers gezielt überbrücken, wobei dann der so justierte Spannungsteiler die Amplitude der am Anschluß C abgegebenen Beschleunigungssignale beeinflußt, also diese Beschleunigungssignale kalibriert.

Man kann jedoch auch die einzelnen Abschnitte des Spannungsteilers durch niederohmige Halbleiterstrecken überbrücken, wobei zur Justierung des Spannungsteiles entsprechend dem Kalibrierwert einzelne dieser Überbrückungen durch einen oder mehrere Spannungsimpulse unterbrochen werden können. Auch dann gestattet der so mit den Spannungsimpulsen justierte Spannungsteiler die Beschleunigungssignale zu kalibrieren.

Der Spannungsteiler kann jedoch auch aus einer Serienschaltung von MOS-FET-Kanälen bestehen, wobei die Steuerspannung an diesen FETs mittels der zugeführten Spannungsimpulse justiert werden können, - ebenfalls z.B. durch Unterbrechen von Halbleiterstrecken oder durch Umwandeln von Zenerdioden in Kurzschlüsse.

Bei dem Justieren der Empfindlichkeit können im gleichen Prozeßschritt, also z.B. am Meßplatz M2, auch andere Größen dieser Sensoreinheiten - je nach ihren zusätzlichen Eigenschaften - wie Selftest, Offset, Nichtlinearität oder Taktfrequenz bei digitalem Ausgangssignal ebenfalls justiert werden.

Jeder erfindungsgemäß zur Justierung benutzte Spannungsimpuls kann Z.B. durch einen Automaten der Fertigungsanlage einem oder mehreren Anschlüssen der Elektronikeinheit E/T zugeleitet oder indirekt mittels des Automaten innerhalb der Elektronikeinheit E/T erzeugt werden. Auch das benötigt nur einen sehr kleinen Aufwand, was für die Großserienfertigung besonders günstig ist.

Man kann auf besonders einfache, für Großserienfertigung geeignete Weise die zur Messung nötigen Spannungen zuführen, wenn man für die Messungen M1, M2 die Betriebsspannungen - und die dann evtl. zusätzlich nötigen Steuerspannungen - über einen mit mindestens einem einzigen Kontaktfinger ausgestatteten Roboterarm der Elektronikeinheit E/T zuführt, um die Elektronikeinheit E/T entsprechend betriebsfähig zu machen.

Bei dem erfindungsgemäßen verfahren kann eine besonders hohe Justiergenauigkeit mit sehr wenig Aufwand erreicht werden, wenn, wie anhand der Figur 3 beispielhaft gezeigt wurde, die Sensoreinheit zwischen der ersten Messung M1 und der zweiten Messung M2 um angenähert 180° gekippt wird, wobei die Sensoreinheit in ihren beiden Stellungen während der Messungen M1, M2 jeweils so gehalten wird, daß sich die seismische Masse des Beschleunigungssensors unter dem Einfluß der Gravitation möglichst stark bewegt. Dann ist die Differenz der gemessenen Ausgangssignale maximal groß: sie entspricht nämlich dem Einfluß der doppelten Erdbeschleunigung 2g auf die seismische Masse. Überdies ist dann die Meßgenauigkeit der Sensoreinheit besonders groß:

Die Figur 4 veranschaulicht den Einfluß der Änderung des Kippwinkels w des Beschleunigungssensors S auf das Ausgangssignal b dieses Beschleunigungssensors S. Betrachtet sei dazu auch die Figur 3. Wenn der Beschleunigungssensor S am ersten Meßplatz M1 oder, um 180° gekippt, am zweiten Meßplatz M2 ist, dann wird seine seismische Masse K maximal in die eine und in die andere entgegengesetzte Richtung ausgelenkt und das Ausgangssignal b ist an beiden Meßplätzen besonders groß, - wobei an diesen beiden Meßplätzen, wie die Figur 4 zeigt, eine versehentlich geringe Änderung des Kippwinkels w jeweils nur noch sehr wenig Einfluß auf die Höhe des Ausgangssignales b hat.

Wenn aber der Beschleunigungssensor S nur um 90° gegenüber der Stellung am ersten Meßplatz gekippt wird, vgl. die Stelle M0 am Band L in der Figur 3, dann wird dort seine seismische Masse K überhaupt nicht von der Gravitation g in die eine und in die andere entgegengesetzte Richtung ausgelenkt. Dann beträgt das Ausgangssignal b Null, vgl. M0 in der Figur 4, wobei dort jede geringe Änderung des Kippwinkels w jeweils nur besonders viel Einfluß auf die Höhe des Ausgangssignales b hat. Es ist also auch hinsichtlich der Meßgenauigkeit des Beschleunigungssensors S günstig, die erste und die zweite Messung bei den Kippwinkeln durchzuführen, die den in der Figur 3 gezeigten Stellungen des Beschleunigungssensors S in den Meßplätzen M1 und M2 entspricht.

Die optimale räumliche Anordnung der Meßplätze M1, M2 hängt daher ab von der Schwingrichtung der seismischen Masse K, bezogen auf die Oberfläche des Bandes L Das in der Figur 3 gezeigte Beispiel betrifft vor allem Beschleunigungssensoren S, bei denen die seismische Masse K entsprechend der Figur 3 senkrecht zum Boden des Gehäuseteils G und damit senkrecht zum Band L schwingen kann. Dann ist es optimal, wenn die Messungen M1, M2 an Stellen durchgeführt wird, an denen das Band L wie in der Figur 3 horizontal läuft.

Falls hingegen die seismische Masse K innerhalb der Sensoreinheit S, E/T nur schräg oder senkrecht zu jener Bandoberfläche schwingen kannn, auf der die Sensoreinheit S, E/T befestigt ist, dann ist es viel besser, die Meßplätze M1, M2 räumlich so anzuordnen, daß an ihnen das Band L nicht horizontal, sondern schräg oder senkrecht verbeiläuft - am günstigsten ist es, wenn an beiden Meßplätzen M1, M2 die seismische Masse in Richtung zum Erdmittelpunkt schwingen kann. Günstig ist also, wenn die seismische Masse K am zweiten Meßplatz M2 durch die Gravitation g in eine Richtung gezogen wird, die entgegengesetzt zu der Richtung am ersten Meßplatz M1 ist.

Für die Großserienfertigung ist es besonders günstig, wenn die für die Messungen M1 und M2 nötigen elektrischen Verbindungen zwischen den Anschlüssen P der Elektronikeinheit E/T und des Beschleunigungssensors S hergestellt werden, z.B. durch Bonden, bevor die erste Messung M1 durchgeführt wird. Dadurch, daß zunächst nur diese Verbindungen aber noch nicht die sonstigen - oder noch nicht alle sonstigen - (in der Figur nicht gezeigten) Verbindungen mit den sonstigen Außenanschlüssen der Sensoreinheit hergestellt werden, können sich wahrend der ersten Messung M1 die betreffende, gerade gemessene Sensoreinheit und die übrigen - insbesondere auf dem Band L befestigten - Sensoreinheiten nicht gegenseitig stören. Auch werden dann ungewollte Kurzschlüsse zwischen Anschlüssen der Sensoreinheit S, E/T wahrend den Messungen M1, M2 vermieden, z.B. falls die Sensoreinheiten S, E/T auf einem sog. Leadframe befestigt sind, wenn also die einzelnen Sensoreinheiten S, E/T auf einer - auf dem Band L mitbefestigten - gitterartigen bandförmigen leitenden Metallschicht hintereinander wie die Bilder auf der Filmstreifen optische Projektionen/Kinos angebracht sind.

Für die Großserienfertigung ist es besonders günstig, die Sensoreinheiten auf einem Leadframe anzubringen und mittels des Leadframe die Sensoreinheiten auf dem Band L zu befestigen, wobei nach der zweiten Messung M2, vgl. den Arbeitsplatz B2 hinter dem zweiten Meßplatz M2, auch die elektrischen Anschlüsse einerseits des Beschleunigungssensors S und/oder der Elektronikeinheit E/T und andererseits Teilen des Leadframe endgültig miteinander verbunden - z.B. verbondet - werden. Dann kann man nämlich auch besonders leicht die Sensoreinheiten mittels der Spannungsimpulse kalibrieren/justieren und anschließend voneinander trennen. Dabei kann der Arbeitsplatz B2, vgl. die Figur 3, z.B. auch auf der obersten horizontalen Strecke des Bandes L angebracht werden, was z.B. ermöglicht, die Sensoreinheiten dann mit äußeren Anschlüssen zu verbonden, wenn die Gehäuseteile G in nach oben offener Weise die Sensoreinheiten tragen, statt wie an der in der Figur 3 gezeigten Stelle B2, wo diese Gehäuseteile G die Sensoreinheiten in nach unten offener Weise tragen.

Um in für eine Großserienfertigung besonders geeigneter Weise die justierten Sensoreinheiten endgültig gegen Umwelteinflüsse schützen zu können, kann nach der zweiten Messung M2 - und nach dem endgültigen Herstellen aller im Gehäuseinneren nötigen elektrischen Verbindungen bei B2 - die Sensoreinheit, vgl. den Arbeitsplatz v, luftdicht verschlossen/abgekapselt werden, bevor diese Sensoreinheit endgültig vom Band L getrennt wird.

Die nach dem erfindungsgemäßen Verfahren hergestellten Sensoreinheiten gestatten also, gleichmäßig für alle Sensoreinheiten, unabhängig von der ursprünglichen schlechten Toleranz ihrer Empfindlichkeit, vor allem die enge Toleranz der Sensoreinheiten zu erreichen. Dies wird vor allem erreicht, indem das Ausgangssignal des Beschleunigungssensors bei zwei verschiedenen Lagen des Sensors bezüglich des Erdgravitationsfeldes gemessen wird, und indem die Sensoreinheit mittels Spannungsimpulsen nachträglich justiert wird.

Um einen besonders raumsparenden Aufbau der Sensoreinheit zu erreichen, kann der Beschleunigungssensor S zusammen mit der Elektronikeinheit E/T einen monolithischen Körper bilden.

Um eine besonders toleranzarme Sensoreinheit zu ermöglichen, kann ihre Elektronikeinheit E/T zusätzlich eine Regeleinheit enthalten oder mit einer Regeleinheit verbunden sein, welche zumindest eine der Betriebsspannungen zwischen Schaltungspunkten der Elektronikeinheit E/T auf einen vorgebbaren Wert stabilisiert.

## Patentansprüche

1. Verfahren zur Herstellung einer kalibrierten Sensoreinheit (S, E/T) im Rahmen einer Serienfertigung mittels einer automatisierten Fertigungsanlage, wobei die Sensoreinheit (S, E/T) einen eine seismische Masse (K) aufweisenden Beschleunigungssensor (S) und eine zur Auswertung der Ausgangssignale (b) des Beschleunigungssensors (S) und zur Lieferung von Beschleunigungssignalen (C) dienende Elektronikeinheit (E/T) enthält,
**dadurch gekennzeichnet,**
**daß** die Sensoreinheit (S, E/T) während einer ersten Messung (M1) des Ausgangssignals (b) durch die Fertigungsanlage in einer ersten Stellung gehalten wird, bei der die Gravitation (g) die seismische Masse (K) in eine erste Richtung zieht,
**daß** die Sensoreinheit danach während einer zweiten Messung (M2) des Ausgangssignales (b) durch die Fertigungsanlage in einer zweiten Stellung gehalten wird, die gegenüber der ersten Stellung so gekippt ist, daß die Gravitation (g) die seismische Masse (K) in eine zweite Richtung zieht, die sich von der ersten Richtung deutlich unterscheidet,
**daß** anschließend die bei beiden Messungen (M1, M2) gemessenen Ausgangssignale (b) verglichen werden, wobei aus dem Ergebnis des Vergleichs ein Kalibrierwert abgeleitet wird, der den Einfluß der Gravitation (g) auf das Ausgangssignal (b) beschreibt, und
**daß** schließlich die Elektronikeinheit (E/T) entsprechend dem Kalibrierwert durch Anlegen von elektrischen Impulsen so justiert (Z) wird, daß die Elektronikeinheit (E/T) später die Ausgangssignale (b) in kalibrierte Beschleunigungssignale (C) umwandeln kann,
wobei die Fertigungsanlage ein Band (L) bewegt, auf dem mehrere Sensoreinheiten (S, E/T; G) in Reihe hintereinander so befestigt sind, daß sie beim Fortbewegen des Bandes (L) nacheinander in einer ersten Stellung an einem ersten Meßplatz (M1) der Fertigungsanlage zur automatischen ersten Messung vorbeilaufen, und das Band (L) danach einen Bogen nach oben oder unten durchläuft, so daß die Sensoreinheiten (S, E/T; G) in einer zweiten, gegenüber der ersten Stellung gekippten Stellung an einem zweiten Meßplatz (M2) zur automatischen zweiten Messung vorbeilaufen.

2. Verfahren nach Patentanspruch 1,
**dadurch gekennzeichnet,**
**daß** die Elektronikeinheit (E/T) mindestens einen Spannungs teiler enthält, wobei der Spannungsteiler entsprechend dem Ergebnis des Vergleichs (über A) so justiert wird, daß die Elektronikeinheit (E/T) später die Ausgangssignale (b) in kalibrierte Beschleunigungssignale (C) umwandeln kann.

3. Verfahren nach Patentanspruch 2,
**dadurch gekennzeichnet,**
**daß** der Spannungsteiler aus mehreren Teilen besteht, von denen mindestens ein Teil durch Zenerdioden (Z) überbrückt ist, wobei zur Justierung des Spannungsteilers entsprechend dem Kalibrierwert ein Teil dieser Zenerdioden (Z) durch einen Spannungsimpuls (über A) in einen Kurzschluß umgewandelt wird.

4. Verfahren nach Patentanspruch 2,
**dadurch gekennzeichnet,**
**daß** der Spannungsteiler aus mehreren Teilen besteht, von denen mindestens ein Teil durch niederohmige Halbleiterstrecken überbrückt ist, wobei zur Justierung des Spannungsteilers entsprechend dem Kalibrierwert ein Teil dieser Halbleiterstrecken durch einen Spannungsimpuls (über A) unterbrochen wird.

5. Verfahren nach Patentanspruch 3 oder 4,
**dadurch gekennzeichnet,**
**daß** der Spannungsimpuls durch einen Automaten der Fertigungsanlage (über A) der Elektronikeinheit (E/T) zugeleitet oder durch den Automaten in der Elektronikeinheit (E/T) erzeugt wird.

6. Verfahren nach einem der vorhergehenden Patentansprüche,
**dadurch gekennzeichnet,**
**daß** für die Messungen (M1, M2) Spannungen über einen mit mindestens einem Kontaktfinger ausgestatteten Roboterarm der Elektronikeinheit (E/T) zugeführt werden, um die Elektronikeinheit (E/T) betriebsfähig zu machen.

7. Verfahren nach Patentanspruch 1,
**dadurch gekennzeichnet,**
**daß** das Band so geführt wird, daß die Richtung der ersten Stellung gegenüber der Richtung der zweiten Stellung um angenähert 180° gedreht ist, so daß sich die seismische Masse (K) des Beschleunigungssensors (S) unter dem Einfluß der Gravitation (g) möglichst stark bewegt und der Vergleich der Ergebnisse der beiden Messungen dem Einfluß der doppelten Erdbeschleunigung (2g) auf die seismische Masse (K) entspricht.

8. Verfahren nach Patentanspruch 1 oder 7,
**dadurch gekennzeichnet,**
**daß**, bevor die erste Messung (M1) durchgeführt wird, nur die für die Messung notwendigen elektrischen Anschlüsse (P) von Elektronikeinheit (E/T) und Beschleunigungssensor (S) (bei B1) miteinander verbunden werden.

9. Verfahren nach einem der Patentansprüche 1, 7 und 8
**dadurch gekennzeichnet,**
**daß** die Sensoreinheiten (S, E/T) auf einem Leadframe angebracht sind, welches auf dein Band (L) befestigt ist, und daß nach der zweiten Messung (M2, bei B2) die übrigen elektrischen Anschlüsse zwischen Beschleunigungssensor (S), Elektronikeinheit (E/T) und Teilen des Leadframe miteinander verbunden werden.

10. Verfahren nach einem der Patentansprüche 1 und 7 bis 9,
**dadurch gekennzeichnet,**
**daß** nach der zweiten Messung (M2) die Sensoreinheit (S, E/T; G) zum Schutz gegen äußere Einflüsse (bei V) luftdicht verschlossen wird, bevor sie vom Band (L) getrennt wird.

11. Sensoreinheit, hergestellt nach einem der vorhergehenden Patentansprüche,
**dadurch gekennzeichnet,**
**daß** der Beschleunigungssensor (S) zusammen mit der Elektronikeinheit (E/T) einen monolithischen Körper bildet.

12. Sensoreinheit nach Patentanspruch 11,
**dadurch gekennzeichnet,**
**daß** ihre Elektronikeinheit (E/T) eine Regeleinheit enthält oder mit einer Regeleinheit verbunden ist, welche zumindest eine der Betriebsspannungen zwischen Schaltungspunkten der Elektronikeinheit (E/T) auf einen vorgebbaren Wert stabilisiert.

## Claims

1. Method for manufacturing a calibrated sensor unit (S, E/T) as part of a mass production process by means of an automated manufacturing system, the sensor unit (S, E/T) containing an acceleration sensor (S) having a seismic mass (K) and an electronic unit (E/T) for evaluating the output signals (b) of the acceleration sensor (S) and for supplying acceleration signals (C),
**characterised in that**
the sensor unit (S, E/T) is maintained by the manufacturing system in a first position during a first measurement (M1) of the output signal (b), the gravitation (g) pulling the seismic mass (K) in a first direction,
the sensor unit is subsequently, during a second measurement (M2) of the output signal (b), maintained by the manufacturing system in a second position which is inclined relative to the first position in such a way that the gravitation (g) pulls the seismic mass (K) in a second direction that differs markedly from the first direction,
the output signals (b) measured in the two measurements (M1, M2) are subsequently compared with each other and a calibration value is derived from the result of the comparison, said calibration value describing the effect of the gravitation (g) on the output signal (b), and
finally, the electronic unit (E/T) is adjusted (Z) in accordance with the calibration value by electrical pulses being applied in such a way that the electronic unit (E/T) can later convert the output signals (b) into calibrated acceleration signals (C),
the manufacturing system moving a belt (L) on which multiple sensor units (S, E/T; G) are mounted in sequence in such a way that when the belt (L) moves forward they pass a first measuring station (M1) of the manufacturing system in succession in a first position for automatic first measurement, and the belt (L) then following a curve upwards or downwards such that the sensor units (S, E/T; G) pass a second measuring station (M2) in a second position inclined relative to the first position for automatic second measurement.

2. Method according to Claim 1,
**characterised in that**
the electronic unit (E/T) contains at least one voltage divider, said voltage divider being adjusted in accordance with the result of the comparison (via A) in such a way that the electronic unit (E/T) can later convert the output signals (b) into calibrated acceleration signals (C).

3. Method according to Claim 2,
**characterised in that**
the voltage divider consists of multiple parts, at least one part of which is bridged by Zener diodes (Z), some of these Zener diodes (Z) being converted to a short-circuit by means of a voltage pulse (via A) for the purpose of adjusting the voltage divider in accordance with the calibration value.

4. Method according to Claim 2,
**characterised in that**
the voltage divider consists of multiple parts, at least one part of which is bridged by low-resistance semiconductor paths, some of these semiconductor paths being open-circuited by means of a voltage pulse (via A) for the purpose of adjusting the voltage divider in accordance with the calibration value.

5. Method according to Claim 3 or 4,
**characterised in that**
the voltage pulse is applied to the electronic unit (E/T) by an automaton of the manufacturing system (via A) or is generated by the automaton in the electronic unit (E/T).

6. Method according to one of the preceding claims,
**characterised in that**
for the purpose of the measurements (M1, M2), voltages are supplied to the electronic unit (E/T) via a robot arm equipped with at least one contact finger in order to make the electronic unit (E/T) operational.

7. Method according to Claim 1,
**characterised in that**
the belt (L) is controlled in such a way that the direction of the first position is turned through approximately 180° relative to the direction of the second position such that the seismic mass (K) of the acceleration sensor (S) is moved as forcefully as possible under the effect of gravitation (g) and the comparison of the results of the two measurements corresponds to the effect of the double gravitational acceleration (2g) on the seismic mass (K).

8. Method according to Claim 1 or 7,
**characterised in that**
before the first measurement (M1) is performed, only the electrical connections (P) of electronic unit (E/T) and acceleration sensor (S) (in the case of B1) that are necessary for the measurement are connected to one another.

9. Method according to one of the Claims 1, 7 and 8,
**characterised in that**
the sensor units (S, E/T) are mounted on a leadframe which is secured to a belt (L), and after the second measurement (M2 in the case of B1) is performed, the remaining electrical connections between acceleration sensor (S), electronic unit (E/T) and parts of the leadframe are connected to one another.

10. Method according to one of the Claims 1 and 7 to 9,
**characterised in that**
after the second measurement (M2) is performed, the sensor unit (S, E/T; G) is sealed so as to be airtight in order to protect it against external influences (in the case of V) before it is separated from the belt (L).

11. Sensor unit manufactured according to one of the preceding claims,
**characterised in that**
the acceleration sensor (S) in combination with the electronic unit (E/T) forms a monolithic body.

12. Sensor unit according to Claim 11,
**characterised in that**
its electronic unit (E/T) contains a control unit or is connected to a control unit which stabilises at least one of the operating voltages between circuit points of the electronic unit (E/T) to a predefinable value.

## Revendications

1. Procédé pour la fabrication d'une unité de capteur calibrée (S, E/T) dans le cadre d'une fabrication en série au moyen d'une installation de fabrication automatisée, l'unité de capteur (S, E/T) contenant un capteur d'accélération (S) comportant une masse sismique (K) et une unité électronique (E/T) servant à l'exploitation des signaux de sortie (b) du capteur d'accélération (S) et à la fourniture de signaux d'accélération (C),**caractérisé en ce que**,
l'unité de capteur (S, E/T) est maintenue pendant une première mesure (M1) du signal de sortie (b) par l'installation de fabrication dans une première position, dans laquelle la pesanteur (g) attire la masse sismique (K) dans une première direction,
**en ce que** l'unité de capteur est ensuite maintenue pendant une deuxième mesure (M2) du signal de sortie (b) par l'installation de fabrication dans une deuxième position qui est basculée par rapport à la première position de telle manière que la pesanteur (g) attire la masse sismique (K) dans une deuxième direction qui est nettement différente de la première direction,
**en ce que**, ensuite, les signaux de sortie (b) mesurés lors des deux mesures (M1, M2) sont comparés, le résultat de la comparaison donnant une valeur de calibrage qui décrit l'influence de la pesanteur (g) sur le signal de sortie (b), et
**en ce que**, finalement, l'unité électronique (E/T) est réglée (Z) conformément à la valeur de calibrage par application d'impulsions électriques de telle manière que l'unité électronique (E/T) peut transformer ultérieurement les signaux de sortie (b) en signaux d'accélération calibrés (C),
l'installation de fabrication déplaçant une bande (L), sur laquelle plusieurs unités de capteur (S, E/T; G) sont fixées en série l'une derrière l'autre de sorte que, lors de l'avancement de la bande (L), elles passent l'une après l'autre par une première position à un premier emplacement de mesure (M1) de l'installation de fabrication pour la première mesure automatique, et
la bande (L) faisant ensuite un coude vers le haut ou vers le bas de telle manière que les unités de capteurs (S, E/T; G) passent dans une deuxième position basculée par rapport à la première position en un deuxième emplacement de mesure (M2) pour la deuxième mesure automatique.

2. Procédé selon la revendication 1, **caractérisé en ce que**, l'unité électronique (E/T) contient au moins un diviseur de tension, le diviseur de tension étant réglé conformément au résultat de la comparaison (par A) de telle manière que l'unité électronique (E/T) peut ensuite transformer les signaux de sortie (b) en signaux d'accélération calibrés (C).

3. Procédé selon la revendication 2, **caractérisé en ce que**, le diviseur de tension est composé de plusieurs parties dont au moins une partie est shuntée par des diodes Zener (Z), une partie de ces diodes Zener (Z) étant transformée par une impulsion de tension (par A) en un court-circuit pour le réglage du diviseur de tension conformément à la valeur de calibrage.

4. Procédé selon la revendication 2, **caractérisé en ce que**, le diviseur de tension est composé de plusieurs parties dont au moins une partie est shuntée par des parcours de semi-conducteurs de faible impédance, une partie de ces parcours de semi-conducteurs étant interrompue par une impulsion de tension (par A) pour le réglage du diviseur de tension conformément à la valeur de calibrage.

5. Procédé selon la revendication 3 ou 4, **caractérisé en ce que**, l'impulsion de tension est appliquée par un automate de l'installation de fabrication (par A) de l'unité électronique (E/T) ou est produite par l'automate dans l'unité électronique (E/T).

6. Procédé selon l'une des revendications précédentes, **caractérisé en ce que**, pour les mesures (M1, M2), des tensions sont appliquées par un bras de robot de l'unité électronique (E/T) équipé d'au moins un doigt de contact, pour mettre l'unité électronique (E/T) en état de fonctionnement.

7. Procédé selon la revendication 1, **caractérisé en ce que**, la bande est guidée de telle manière que la direction de la première position est tournée d'environ 180° par rapport à la direction de la deuxième position, de sorte que la masse sismique (K) du capteur d'accélération (S) se déplace le plus fortement possible sous l'influence de la pesanteur (g) et la comparaison des résultats des deux mesures correspond à l'influence du double de l'accélération terrestre (2g) sur la masse sismique (K).

8. Procédé selon la revendication 1 ou 7, **caractérisé en ce que**, avant exécution de la première mesure (M1), seuls les raccordements électriques (P) de l'unité électronique (E/T) et du capteur d'accélération (S) (en B1) nécessaires pour la mesure sont reliés l'un à l'autre.

9. Procédé selon l'une des revendications 1, 7 ou 8, **caractérisé en ce que**, les unités de capteur (S, E/T) sont placées sur un cadre de montage qui est fixé sur la bande (L) et **en ce que**, après la deuxième mesure (M2, en B2), les autres raccordements électriques entre capteur d'accélération (S), unité électronique (E/T) et parties du cadre de montage sont reliés l'un à l'autre.

10. Procédé selon l'une des revendications 1 ou 7 à 9, **caractérisé en ce que**, après la deuxième mesure (M2), l'unité de capteur (S, E/T; G) est fermée de manière étanche à l'air pour la protection contre les influences extérieures (en V), avant d'être séparée de la bande (L).

11. Unité de capteur, fabriquée selon l'une des revendications précédentes, **caractérisé en ce que**, le capteur d'accélération (S) forme avec l'unité électronique (E/T) un corps monolithique.

12. Unité de capteur selon la revendication 11, **caractérisé en ce que**, son unité électronique (E/T) contient une unité de réglage ou est reliée à une unité de réglage qui stabilise à une valeur prédéterminable au moins une des tensions de fonctionnement entre des points de branchement de l'unité électronique (E/T).
